# EUROPEAN PATENT APPLICATION

(11) **EP 4 503 007 A1**
(43) Date of publication of application: **05.02.2025**
(21) Application number: 24190903.5
(22) Date of filing: 25.07.2024
(51) Int. Cl.: G09G 3/3233, G06F 3/041

(54) **SENSOR AND DISPLAY DEVICE**

(30) Priority: 02.08.2023 KR 20230101286
(71) Applicant: Samsung Display Co., Ltd., Gyeonggi-do (KR)
(72) Inventor: Kim, Hyomin, Yongin-si, Gyeonggi-Do (KR)
(74) Representative: Gulde & Partner

(57) **Abstract**

A display device (DD) according to the invention includes at least one pixel (PX) including a light emitting element (ED) connected to a driving voltage line (VL2) transferring a driving voltage (ELVSS); at least (SX) including a light sensing element (OPD) connected to the driving voltage line (VL2) and a reset voltage line (VL5) receiving a reset voltage (VRST); a driving controller (120) configured to receive an image signal (RGB) and a control signal (CTRL); and a voltage generator (500) configured to generate the driving voltage (ELVSS) and the reset voltage (VRST) in response to a voltage control signal (VCS), wherein the driving controller (120) is configured to: determine a voltage level of the driving voltage (ELVSS) based on the image signal (RGB) and the control signal (CTRL); determine a voltage level of the reset voltage (VRST) based on the determined voltage level of the driving voltage (ELVSS); and output the voltage control signal (VCS) corresponding to the voltage level of the driving voltage (ELVSS) and the voltage level of the reset voltage (VRST).

## Description

### 1. Technical Field

Embodiments of the present disclosure described herein are directed to a display device including a sensor.

### 2. Discussion of Related Art

A multimedia electronic device such as a television (TV), a mobile phone, a tablet computer, a navigation system, or a game console includes a display device for displaying an image. In addition to a general input device such as a button, a keyboard, or a mouse, an electronic device may include a display device capable of providing a touch-based input scheme that allows a user to enter information or commands easily and intuitively.

A display panel of the display device may include sensors that enable the touch-based input scheme to operate. The sensors may receive reset voltages through reset lines and driving voltages through voltage lines. However, levels of driving voltages or the reset voltages may vary depending on locations of the driving lines or reset lines and based on whether levels of the driving voltages have changed, thereby reducing performance of the sensor.

### SUMMARY

At least one embodiment of the present disclosure provide a display device capable of maintaining performance of a sensor even though a voltage level of a driving voltage provided to a pixel and the sensor changes.

According to an embodiment, a sensor includes a light sensing element, a first transistor, a second transistor, and a third transistor. The light sensing element is connected between a sensing node and a driving voltage line. The first transistor is connected between a reset voltage line and the sensing node. The second transistor is connected between a sensor driving voltage line and an intermediate node and including a gate electrode connected to the sensing node. The third transistor is connected between the intermediate node and a readout line and including a gate electrode connected to a scan line. A voltage level of a reset voltage provided to the reset voltage line is changed depending on a voltage level of a driving voltage provided to the driving voltage line. For example, a driving controller may determine the voltage level of the driving voltage and change the reset voltage based on the determined voltage level of the driving voltage.

In an embodiment, the first transistor may be a transistor of a first type, and each of the second transistor and the third transistor may be a transistor of a second type different from the first type.

In an embodiment, the first transistor may include a gate electrode receiving a reset signal, and a voltage level of the reset signal may be changed depending on the voltage level of the driving voltage.

In an embodiment, the light sensing element may include an anode connected to the sensing node and a cathode connected to the driving voltage line.

According to an embodiment, a display device includes a pixel, a sensor, a driving controller, and a voltage generator. The pixel includes a light emitting element connected to a driving voltage line transferring a driving voltage. The sensor includes a light sensing element connected to the driving voltage line and a reset voltage line receiving a reset voltage. The driving controller receives an image signal and a control signal. The voltage generator generates the driving voltage and the reset voltage in response to a voltage control signal. The driving controller determines a voltage level of the driving voltage based on the image signal and the control signal, determines a voltage level of the reset voltage based on the determined voltage level of the driving voltage, and outputs the voltage control signal corresponding to the voltage level of the driving voltage and the voltage level of the reset voltage.

In an embodiment, the sensor may include the light sensing element connected between a sensing node and the driving voltage line, a first transistor connected between the reset voltage line and the sensing node, a second transistor connected between a sensor driving voltage line and an intermediate node and including a gate electrode connected to sensing node, and a third transistor connected between the intermediate node and a readout line and including a gate electrode connected to a scan line.

In an embodiment, the first transistor may be a transistor a first type, and the second transistor and the third transistor may be transistors of a second type different from the first type.

In an embodiment, the light sensing element may include a cathode connected to the driving voltage line and an anode connected to the sensing node, and the light emitting element may include a cathode connected to the driving voltage line and an anode.

In an embodiment, the driving controller may include a memory that stores a voltage data signal including information about a voltage distribution of the driving voltage provided to a display panel, and a controller that receives the voltage data signal from the memory, determines a voltage level of a reset control voltage based on the voltage data signal, and outputs the voltage control signal corresponding to the voltage level of the reset control voltage.

In an embodiment, the voltage generator may further generate the reset control voltage in response to the voltage control signal.

In an embodiment, the display device may further include a sensor driver that outputs a scan signal for driving the pixel and outputs a reset signal for driving the sensor.

In an embodiment, the sensor driver may output the reset signal corresponding to the voltage level of the reset control voltage.

In an embodiment, the first transistor may include a gate electrode receiving the reset signal.

According to an embodiment, a display device may include a display panel, a driving controller, and a voltage generator. The display panel includes pixels and sensors. The driving controller receives an image signal and a control signal. The voltage generator generates a driving voltage and a reset voltage in response to a voltage control signal. Each of the sensors includes a light sensing element connected to a driving voltage line receiving the driving voltage and a reset voltage line receiving the reset voltage. The driving controller determines a voltage level of the driving voltage based on the image signal and the control signal, determines a voltage level of the reset voltage based on the determined voltage level of the driving voltage, and outputs the voltage control signal corresponding to the voltage level of the driving voltage and the voltage level of the reset voltage.

In an embodiment, the display device may further include a sensor driver that outputs scan signals for driving the pixels and outputs reset signals for driving the sensors.

In an embodiment, the voltage generator may further generate a reset control voltage in response to the voltage control signal, and the sensor driver may output the reset signals corresponding to a voltage level of the reset control voltage.

In an embodiment, the display panel may include a first area and a second area, and the sensors may include a first sensor disposed in the first area and a second sensor disposed in the second area.

In an embodiment, the reset signals may include a first reset signal to be provided to the first sensor and a second reset signal to be provided to the second sensor, and a voltage level of the first reset signal and a voltage level of the second reset signal may be different from each other.

In an embodiment, the first sensor may include a first light sensing element connected between a first sensing node and the driving voltage line, and a first transistor connected between the reset voltage line and the first sensing node and including a gate electrode receiving the first reset signal. The second sensor may include a second light sensing element connected between a second sensing node and the driving voltage line, and a second transistor connected between the reset voltage line and the second sensing node and including a gate electrode receiving the second reset signal.

In an embodiment, the display panel may further include a base layer, a circuit layer disposed on the base layer, the first transistor and the second transistor being disposed in the circuit layer, and an element layer disposed on the circuit layer and including the first light sensing element and the second light sensing element.

### BRIEF DESCRIPTION OF THE FIGURES

FIG. 1 is a perspective view illustrating a display device according to an embodiment of the present disclosure.
FIG. 2 is a cross-sectional view of a display device according to an embodiment of the present disclosure.
FIG. 3 is a block diagram of a display device according to an embodiment of the present disclosure.
FIG. 4 is an enlarged plan view of a partial area of a display panel according to an embodiment of the present disclosure.
FIG. 5 is a circuit diagram of a pixel and a sensor according to an embodiment of the present disclosure.
FIG. 6 is a timing diagram for an operation of a pixel illustrated in FIG. 5.
FIG. 7 is a timing diagram for an operation of a sensor illustrated in FIG. 5.
FIG. 8 is a cross-sectional view of a display panel according to an embodiment of the present disclosure.
FIGS. 9A and 9B are diagrams illustrating a voltage distribution of a second driving voltage in a display panel.
FIG. 10 is a diagram illustrating a change in a current density of a light sensing element.
FIG. 11 is a block diagram of a driving controller according to an embodiment of the present disclosure.
FIG. 12 is a diagram illustrating pixels and sensors disposed in a display panel.
FIGS. 13A, 13B, and 13C are diagrams illustrating reset signals provided to reset lines illustrated in FIG. 12.

### DETAILED DESCRIPTION

Embodiments will now be described more fully hereinafter with reference to the accompanying drawings. Embodiments may, however, be provided in different forms and should not be construed as limiting. The same reference numbers may indicate the same components throughout the disclosure.

In the specification, the expression that a first component (or region, layer, part, etc.) is "on", "connected to", or "coupled to" a second component means that the first component is directly on, connected to, or coupled to the second component or means that a third component is interposed therebetween.

Below, embodiments of the present disclosure will be described with reference to drawings.

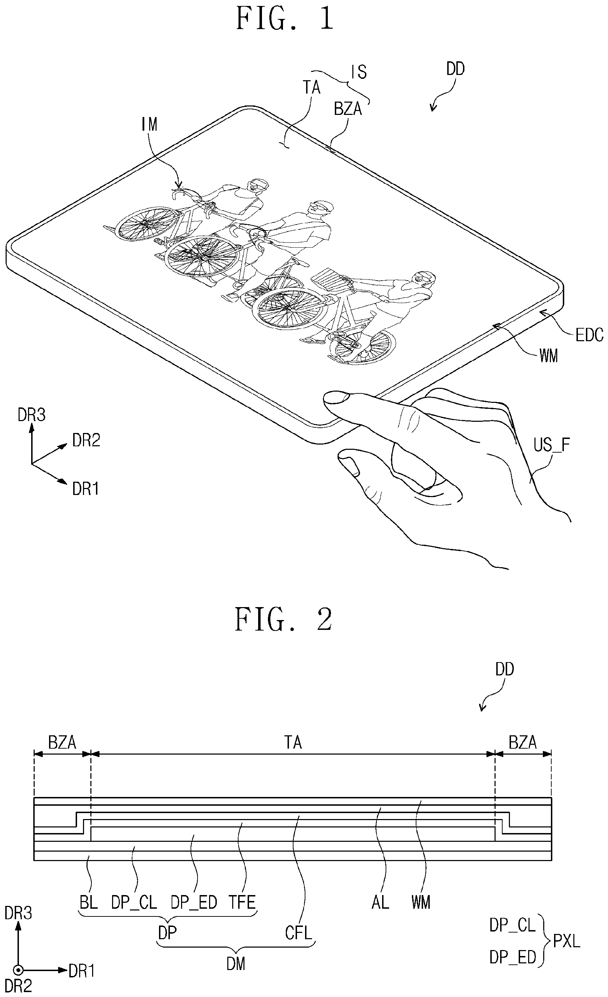

FIG. 1 is a perspective view of a display device DD according to an embodiment of the present disclosure. FIG. 2 is a cross-sectional view of the display device DD according to an embodiment of the present disclosure.

Referring to FIGS. 1 and 2, the display device DD may be a device that is activated depending on an electrical signal. For example, the display device DD may be a mobile phone, a tablet, a car navigation system, a game console, or a wearable device, but the present disclosure is not limited thereto. An example in which the display device DD is a smartphone is illustrated in FIG. 1.

While a rigid-type display device DD of a bar shape is illustrated in FIG. 1 as an example, the present disclosure is not limited thereto. For example, the display device DD may be the foldable, rollable, or slidable display device DD.

An upper surface of the display device DD may be defined as a display surface IS and may have a plane defined by a first direction DR1 and a second direction DR2. Images IM generated by the display device DD may be provided to the user through the display surface IS. A normal direction that is substantially perpendicular to the plane defined by the first direction DR1 and the second direction DR2 is defined as a third direction DR3. In the specification, the expression "when viewed from above a plane" may mean "when viewed in the third direction DR3". That is, the plane may be parallel to the surface defined by the first direction DR1 and the second direction DR2.

The display surface IS may be divided into a transparent area TA and a bezel area BZA. The transparent area TA may be an area in which the images IM are displayed. The user visually perceives the images IM through the transparent area TA. In an embodiment, the transparent area TA is illustrated in the shape of a quadrangle whose vertexes are rounded. However, this is illustrated as an example. The transparent area TA may have various shapes and is not limited to any particular shape.

The bezel area BZA may be adjacent to the transparent area TA. The bezel area BZA may have a given color. The bezel area BZA may surround the transparent area TA. As such, a shape of the transparent area TA may be defined substantially by the bezel area BZA. However, this is illustrated as an example. The bezel area BZA may be disposed adjacent to only one side of the transparent area TA or may be omitted.

The display device DD may sense an external input applied from the outside. The external input may include various types of inputs that are provided from the outside of the display device DD. For example, as well as a contact by a part of a body such as a user's hand US_F, the external input may include an external input (e.g., hovering) where the user's hand US_F approaches the display device DD or is adjacent to the display device DD within a given distance. Also, the external input may have various types such as a force type, a pressure type, a temperature type, and a light type. The external input may also be provided by a separate device, for example, an active pen or a digitizer pen. Also, the display device DD may sense biometric information of the user applied from the outside.

The exterior of the display device DD may be implemented by a window WM and a housing EDC. For example, the window WM and the housing EDC may be coupled to each other, and the remaining components of the display device DD such as a display module DM may be accommodated within a space formed by the window WM and the housing EDC thus coupled.

A front surface of the window WM may define the display surface IS of the display device DD. The window WM may include an optically transparent material. For example, the window WM may include glass or plastic. The window WM may be of a multi-layer structure or a single-layer structure. For example, the window WM may include a plurality of plastic films bonded to each other by an adhesive or may have a glass substrate and a plastic film bonded to each other by an adhesive.

The housing EDC may include a material whose rigidity is relatively high. For example, the housing EDC may include glass, plastic, or metal or may include a plurality of frames and/or plates that are formed of a combination thereof. The housing EDC may stably protect components of the display device DD, which are accommodated in the inner space, from an external impact. A battery module that supplies a power for the overall operation of the display device DD may be interposed between the display module DM and the housing EDC.

The display module DM may include a display panel DP and an anti-reflection layer CFL.

The display panel DP may be a component that generates an image. The display panel DP may be a light emitting display panel. For example, the display panel DP may be an organic light emitting display panel, an inorganic light emitting display panel, an organic-inorganic light emitting display panel, a quantum dot display panel, a micro-LED display panel, or a nano-LED display panel. Below, the description will be given assuming the display panel DP is the organic light emitting display panel.

The display panel DP includes a base layer BL, a pixel layer PXL, and an encapsulation layer TFE. The display panel DP according to the present disclosure may be a flexible display panel. However, the present disclosure is not limited thereto. For example, the display panel DP may be a foldable display panel, which is folded about a folding axis, or a rigid display panel.

The base layer BL may include a synthetic resin layer. The synthetic resin layer may be a polyimide-based resin layer, and the material thereof is not particularly limited. In one or more embodiments, the base layer BL may include a glass substrate, a metal substrate, and/or an organic/inorganic composite material substrate in addition to the synthetic resin layer or instead of the synthetic resin layer, etc.

The pixel layer PXL is disposed on the base layer BL. The pixel layer PXL may include a circuit layer DP_CL and an element layer DP_ED. The circuit layer DP_CL is interposed between the base layer BL and the element layer DP_ED.

In an embodiment, the circuit layer DP_CL includes at least one insulating layer and a circuit element. Below, the insulating layer included in the circuit layer DP_CL is referred to as an "intermediate insulating layer". In an embodiment, the intermediate insulating layer includes at least one intermediate inorganic film and at least one intermediate organic film. The circuit element may include a pixel circuit included in each of a plurality of pixels for displaying an image and a sensor driving circuit included in each of a plurality of sensors for recognizing external information. The circuit layer DP_CL may further include signal lines connected to the pixel circuit and/or the sensor driving circuit.

As an example of the present disclosure, each of the plurality of sensors may include a fingerprint recognition sensor, a proximity sensor, an iris recognition sensor, etc. Also, each of the plurality of sensors may include an optical sensor that recognizes biometric information in an optical manner. According to an embodiment of the present disclosure, the plurality of sensors may be used to sense an external input (e.g., a touch of the user) as well as biometric information such as a fingerprint. Accordingly, the display device DD need not include a separate input sensing layer for sensing an external input. In this case, the thickness of the display device DD may become thinner, and thus, flexibility may be increased. This may make it possible to implement the display device DD in various types, for example, to implement the foldable, rollable, or slidable display device DD described above.

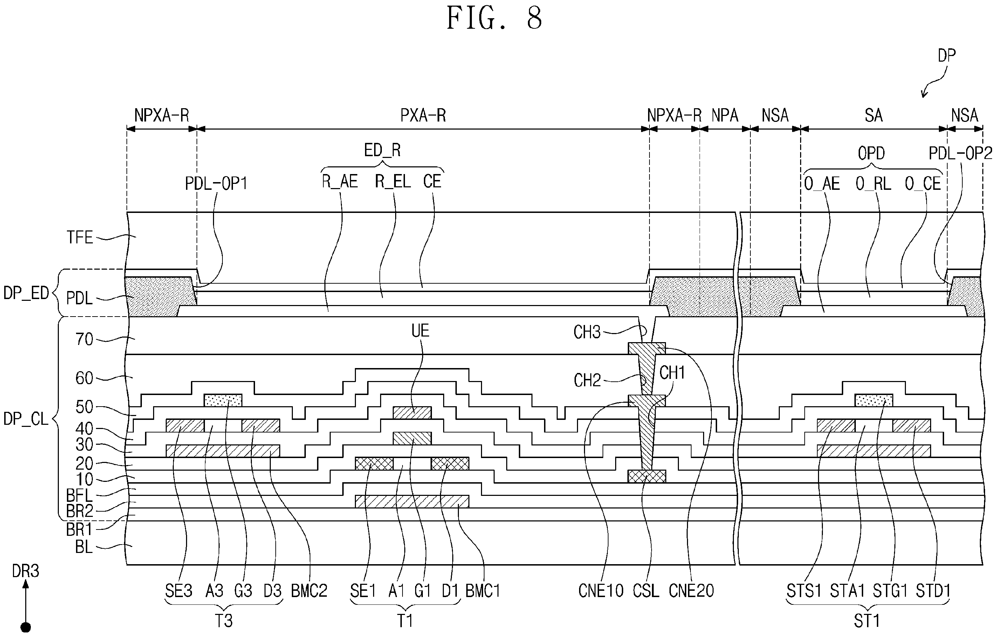

The element layer DP_ED may include a light emitting element included in each of the pixels and a light sensing element included in each of the sensors. As an example of the present disclosure, the light sensing element may be a photodiode. The light sensing element may be a sensor that senses light reflected by a fingerprint of the user or reacts to light. The circuit layer DP_CL and the element layer DP_ED will be described in detail with reference to FIG. 8.

The encapsulation layer TFE seals up the element layer DP_ED. The encapsulation layer TFE may include at least one organic film and at least one inorganic film. The inorganic film may include an inorganic material and may protect the element layer DP_ED from moisture/oxygen. The inorganic film may include a silicon nitride layer, a silicon oxynitride layer, a silicon oxide layer, a titanium oxide layer, an aluminum oxide layer, or etc., but is not limited thereto. The organic film may include an organic material and may protect the element layer DP_ED from foreign objects such as dust particles.

The anti-reflection layer CFL may be disposed on the display panel DP. The anti-reflection layer CFL may reduce the reflectance of external light incident from outside of the display device DD. The anti-reflection layer CFL may be formed on the display panel DP through a continuous process, but the present disclosure is not limited thereto. For example, the anti-reflection layer CFL may include color filters, a black matrix, and a planarization layer. The color filters may have a given arrangement. For example, the color filters may be arranged in consideration of colors of lights emitted from the pixels included in the display panel DP. In an embodiment, the anti-reflection layer CFL includes a black matrix and a reflection control layer. The reflection control layer may selectively absorb light reflected from inside the display panel DP and/or an electronic device and/or light belonging to a partial band from among light incident from outside of the display panel DP and/or the electronic device. In an embodiment, the anti-reflection layer CFL is a polarization film.

The display device DD according to an embodiment of the present disclosure may further include an adhesive layer AL. The window WM may be attached to the anti-reflection layer CFL by the adhesive layer AL. The adhesive layer AL may include an optical clear adhesive, an optically clear adhesive resin, or a pressure sensitive adhesive (PSA).

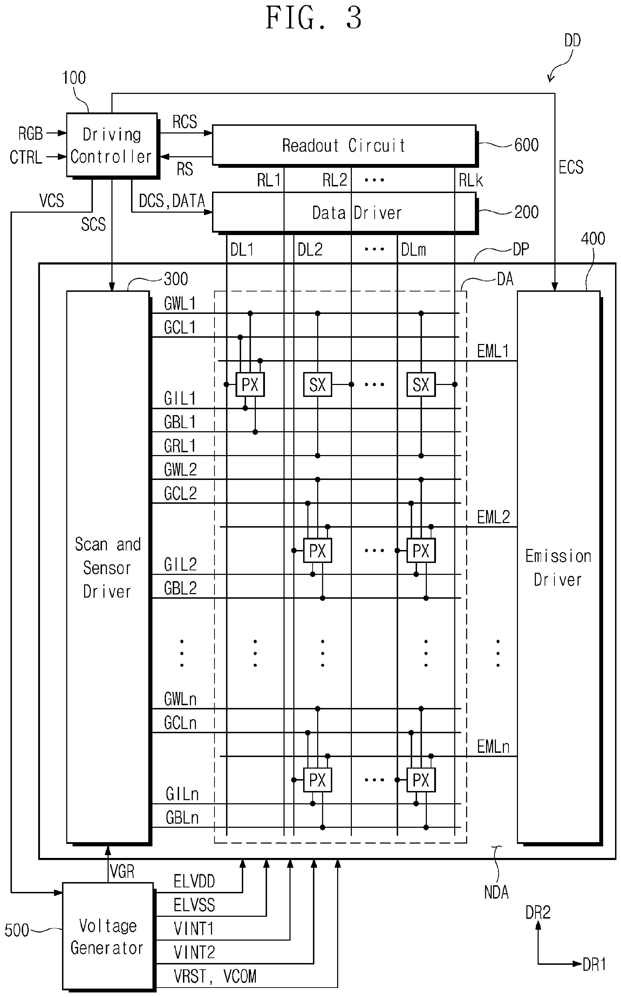

FIG. 3 is a block diagram of a display device according to an embodiment of the present disclosure.

Referring to FIG. 3, the display device DD may include a display panel DP, a driving controller 100 (e.g., a controller circuit), a data driver 200, a scan and sensor driver 300 (e.g., a first driver circuit), an emission driver 400 (e.g., a second driver circuit), a voltage generator 500, and a readout circuit 600.

The driving controller 100 allows an image to be displayed on the display panel DP. The driving controller 100 receives an input image signal RGB and a control signal CTRL. The driving controller 100 generates an output image signal DATA by converting a data format of the input image signal RGB so as to be appropriate for the data driver 200 and the display panel DP. The driving controller 100 outputs a scan control signal SCS, a data control signal DCS, an emission control signal ECS, a readout control signal RCS and a voltage control signal VCS.

The data driver 200 receives the data control signal DCS and the output image signal DATA from the driving controller 100. The data driver 200 converts the output image signal DATA into data signals and then outputs the data signals to a plurality of data lines DL1 to DLm. The data signals may be analog voltages corresponding to a gray level of the output image signal DATA.

The voltage generator 500 generates voltages for the operation of the display panel DP in response to the voltage control signal VCS from the driving controller 100. In an embodiment, the voltage generator 500 may generate a first driving voltage ELVDD, a second driving voltage ELVSS, a first initialization voltage VINT1, a second initialization voltage VINT2, a reset voltage VRST, a sensor driving voltage VCOM, and/or a reset control voltage VGR. In an embodiment, the first driving voltage ELVDD is greater than the second driving voltage ELVSS. In an embodiment, the second driving voltage ELVSS is a ground voltage.

In an embodiment, the voltage generator 500 changes or sets a voltage level of the reset voltage VRST and a voltage level of the reset control voltage VGR in response to the voltage control signal VCS.

The display panel DP includes scan lines GIL1 to GILn, GCL1 to GCLn, GWL1 to GWLn, and GBL1 to GBLn, a reset line GRL1, emission lines EMI,1 to EMI,n, the data lines DL1 to DLm, readout lines RL1 to RLk, pixels PX, and sensors SX. While a single reset line GRL1 is illustrated in FIG. 3, the display panel DP may include a plurality of reset lines.

The display panel DP may include a display area DA corresponding to the transparent area TA (refer to FIG. 1) and a non-display area NDA corresponding to the bezel area BZA (refer to FIG. 1). The pixels PX and the sensors SX may be disposed in the display area DA.

The scan and sensor driver 300 and the emission driver 400 may be disposed in the non-display area NDA of the display panel DP.

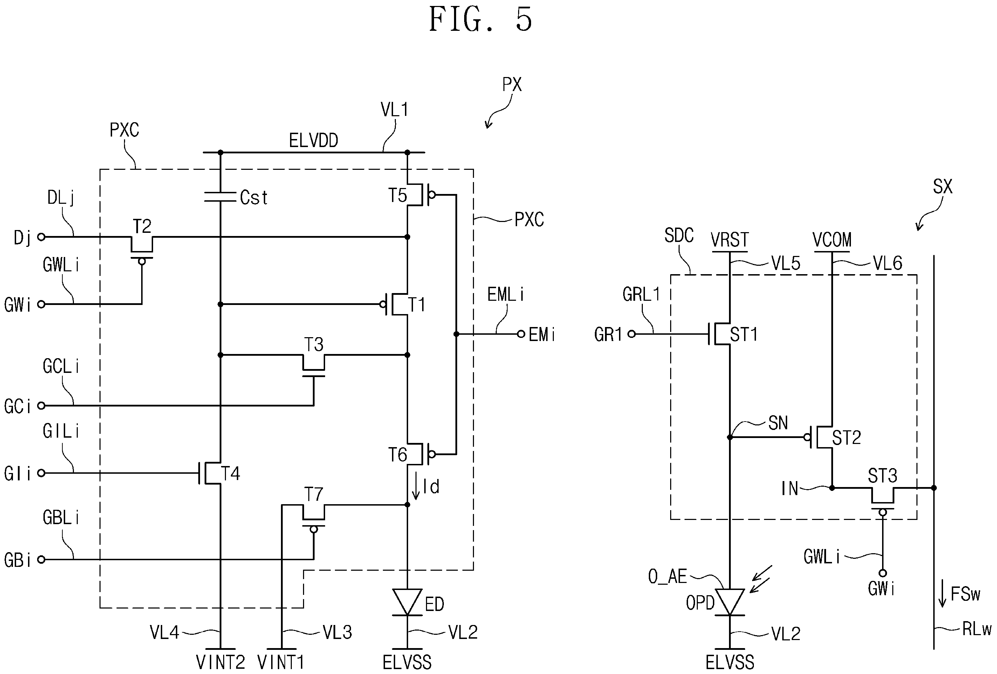

In an embodiment, the scan and sensor driver 300 is disposed adjacent to a first side of the display area DA in the display panel DP. The scan and sensor driver 300 receives the scan control signal SCS from the driving controller 100. In response to the scan control signal SCS, the scan and sensor driver 300 may output scan signals to the scan lines GIL1 to GILn, GCL1 to GCLn, GWL1 to GWLn, and GBL1 to GBLn and may output a reset signal GR1 (refer to FIG. 5) to the reset line GRL1. The scan lines GIL1 to GILn, GCL1 to GCLn, GWL1 to GWLn, and GBL1 to GBLn and the reset line GRL1 may extend from the scan and sensor driver 300 in the first direction DR1.

In an embodiment, the scan and sensor driver 300 determines a voltage level of the reset signal GR1 (refer to FIG. 5) to be provided to the reset line GRL1 based on the reset control voltage VGR received from the voltage generator 500.

The emission driver 400 is disposed adjacent to a second side of the display area DA in the display panel DP. The emission driver 400 receives the emission control signal ECS from the driving controller 100. The emission driver 400 may output emission signals to the emission lines EMI,1 to EMI,n in response to the emission control signal ECS. The emission lines EMI,1 to EMI,n may extend from the emission driver 400 in a direction facing away from the first direction DR1.

The scan lines GIL1 to GILn, GCL1 to GCLn, GWL1 to GWLn, and GBL1 to GBLn, the reset line GRL1, and the emission lines EMI,1 to EMI,n may be arranged to be spaced away from each other in the second direction DR2. The data lines DL1 to DLm may extend from the data driver 200 in a direction facing away from the second direction DR2 and may be arranged to be spaced away from each other in the first direction DR1.

The plurality of pixels PX are electrically connected to the scan lines GIL1 to GILn, GCL1 to GCLn, GWL1 to GWLn, and GBL1 to GBLn, the emission lines EMI,1 to EMI,n, and the data lines DL1 to DLm. In an embodiment, each of the plurality of pixels PX is electrically connected to four scan lines and a single emission line. For example, as illustrated in FIG. 3, the pixels PX belonging to the first row may be connected to the scan lines GIL1, GCL1, GWL1, and GBL1 and the emission line EMI,1. Also, the pixels PX belonging to the second row may be connected to the scan lines GIL2, GCL2, GWL2, and GBL2 and the emission lines EML2.

Each of the plurality of pixels PX includes a light emitting element ED (refer to FIG. 5) and a pixel circuit PXC(refer to FIG. 5) for controlling the emission of the light emitting element ED. The pixel circuit PXC may include one or more transistors and one or more capacitors. The scan and sensor driver 300 and the emission driver 400 may include transistors formed through the same process as the pixel circuit PXC.

Each of the plurality of pixels PX receives the first driving voltage ELVDD, the second driving voltage ELVSS, the first initialization voltage VINT1, and the second initialization voltage VINT2 from the voltage generator 500.

Each of the sensors SX includes a light sensing element OPD (refer to FIG. 5) and a sensor driving circuit SDC (refer to FIG. 5). The sensor driving circuit SDC may include transistors formed through the same process as the pixel circuit PXC.

Each of the sensors SX may be connected to a corresponding scan line among the scan lines GWL1 to GWLn and a corresponding readout line among the readout lines RL1 to RLk. The sensors SX may be connected to the reset line GRL1. In an embodiment, when the number of reset lines GRL1 is plural, the sensors SX may be connected to a corresponding reset line among the plurality of reset lines.

In an embodiment, the number of sensors SX is less than the number of pixels PX. However, the present disclosure is not limited thereto. In an embodiment, the number of sensors SX disposed in the display panel DP is more than or equal to the number of pixels PX. In an embodiment, the number of readout lines RL1 to RLk is less than the number of data lines DL1 to DLm. That is, k < m. However, the present disclosure is not limited thereto. In an embodiment, the number of readout lines RL1 to RLk disposed in the display panel DP is more than or equal to the number of data lines DL1 to DLm.

The readout circuit 600 may receive sensing signals from the readout lines RL1 to RLk to output a readout signal RS to the driving controller 100 in response to the readout control signal RCS.

In an embodiment, the sensors SX and the readout circuit 600 may operate in a biometric sensing mode and a touch sensing mode. In an embodiment, the sensors SX and the readout circuit 600 may sense information about blood pressure and fingerprint of the user in the biometric sensing mode. In an embodiment, the sensors SX and the readout circuit 600 may sense a location of a user touch in the touch sensing mode.

In the example illustrated in FIG. 3, the scan and sensor driver 300 is disposed to face the emission driver 400, with the pixels PX interposed therebetween, but the present disclosure is not limited thereto. For example, the scan and sensor driver 300 and the emission driver 400 may be disposed side by side at a location adjacent to one of the first side and the second side of the display area DA in the display panel DP. In an embodiment, the scan and sensor driver 300 and the emission driver 400 are implemented with a single circuit.

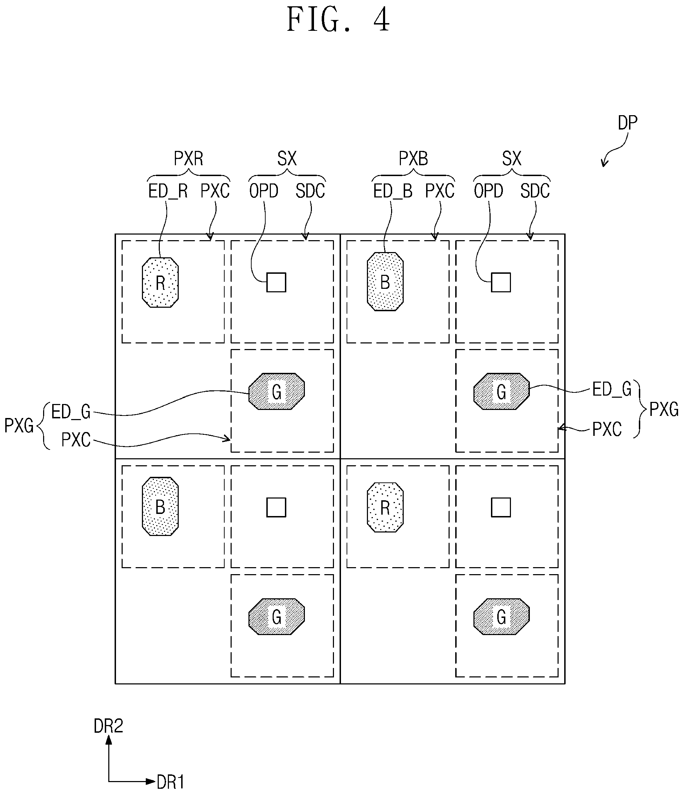

FIG. 4 is an enlarged plan view of a partial area of the display panel DP of FIG 3 according to an embodiment of the present disclosure.

Referring to FIG. 4, pixels PXR, PXG, and PXB are disposed in the display panel DP. The pixels PXR, PXG, and PXB may respectively correspond to the pixels PX illustrated in FIG. 3. Each of the pixels PXR, PXG, and PXB includes a light emitting element (one of ED_R, ED_G, and ED_B) and the pixel circuit PXC. Each of the pixels PX illustrated in FIG. 3 may correspond to one of the pixels PXR, PXG, and PXB illustrated in FIG. 4. Each of the sensors SX includes a light sensing element OPD and a sensor driving circuit SDC.

Referring to FIG. 4, the pixels PXR and PXB and the sensors SX are disposed at odd-numbered rows, that is, the first row and the third row. In an embodiment, the pixels PXR and PXB and the sensors SX are alternately disposed in the first direction DR1 for each of the first and third rows. Only the pixels PXG are disposed in each of the second row and the fourth row.

In an embodiment, the pixel PXR may include the light emitting element ED_R outputting a light of a first color (e.g., a red). The pixel PXG may include the light emitting element ED_G outputting a light of a second color (e.g., a green). The pixel PXB may include the light emitting element ED_B outputting a light of a third color (e.g., a blue).

As illustrated in FIG. 4, the pixels PXR and PXB may be alternately and repeatedly disposed in the second direction DR2 as well as in the first direction DR1. Each of the pixels PXG may be disposed between two light sensing elements OPD that are arranged in the second direction DR2.

While the pixels PXR, PXG, PXB and the sensors SX are illustrated in FIG. 4 as having a specific arrangement, this arrangement may be variously changed or modified.

In an embodiment, the light emitting element ED_R is larger in size than the light emitting element ED_G. Also, the size of the light emitting element ED_B may be larger than or equal to the size of the light emitting element ED_R. The size of each of the light emitting elements ED_R, ED_G, and ED_B is not limited thereto and may be variously changed and applied. For example, in an embodiment of the present disclosure, the light emitting elements ED_R, ED_G, and ED_B have the same size.

Also, each of the light emitting elements ED_R, ED_G, and ED_B may be implemented in various shapes such as a polygon, a circle, or an ellipse. In an embodiment, the light emitting elements ED_R, ED_G, and ED_B are implemented to have different shapes. For example, the light emitting element ED_G may be in the shape of a circle, and the light emitting elements ED_R and ED_B may be in the shape of a quadrangle.

In an embodiment, the area occupied by the sensor driving circuit SDC is different from the area occupied by the pixel circuit PXC. For example, the area of the sensor driving circuit SDC may be smaller than the area of the pixel circuit PXC.

FIG. 5 is a circuit diagram of the pixel PX and the sensor SX according to an embodiment of the present disclosure.

FIG. 5 shows one pixel PX among the plurality of pixels PX illustrated in FIG. 3 and one sensor SX among the plurality of sensors SX illustrated in FIG. 3. Each of the pixels PX illustrated in FIG. 3 may have the same circuit configuration as the pixel PX illustrated in FIG. 5. Also, each of the plurality of sensors SX illustrated in FIG. 3 may have the same circuit configuration as the sensor SX illustrated in FIG. 5.

Referring to FIG. 5, the pixel PX includes the pixel circuit PXC and at least one light emitting element ED. The light emitting element ED may be a light emitting diode. As an example of the present disclosure, the light emitting element ED may be an organic light emitting diode including an organic emission layer. The pixel circuit PXC according to an embodiment includes first to seventh transistors T1, T2, T3, T4, T5, T6, and T7 and one capacitor Cst.

The third and fourth transistors T3 and T4 among the first to seventh transistors T1 to T7 may be N-type transistors. The third and fourth transistors T3 and T4 may use an oxide semiconductor as a semiconductor layer. The first, second, fifth, sixth, and seventh transistors T1, T2, T5, T6, and T7 may be P-type transistors. The P-type transistors may have a low-temperature polycrystalline silicon (LTPS) semiconductor layer. However, the present disclosure is not limited thereto. In an embodiment, all the first to seventh transistors T1 to T7 may be P-type transistors. In an embodiment, all the first to seventh transistors T1 to -T7 may be N-type transistors. In an embodiment, at least one of the first to seventh transistors T1 to T7 may be an N-type transistor, and the others thereof are P-type transistors. A configuration of the pixel circuit PXC according to the present disclosure is not limited to the embodiment illustrated in FIG. 5. The pixel circuit PXC illustrated in FIG. 5 is only an example, and the configuration of the pixel circuit PXC may be variously modified and implemented.

The pixel PX is electrically connected to the scan lines GILi, GCLi, GWLi, and GBLi, the emission line EMI,i, and the data line DLj. The scan lines GILi, GCLi, GWLi, and GBLi may respectively transfer scan signals GIi, GCi, GWi, and GBi, and the emission line EMLi may transfer an emission control signal EMi. The data line DLj transfers a data signal Dj. The data signal Dj may have a voltage level corresponding to the input image signal RGB input to the display device DD (refer to FIG. 3). First to fourth driving voltage lines VL1, VL2, VL3, and VL4 may respectively transfer the first driving voltage ELVDD, the second driving voltage ELVSS, the first initialization voltage VINT1, and the second initialization voltage VINT2.

The first transistor T1 includes a first electrode connected to the first driving voltage line VL1 through the fifth transistor T5, a second electrode electrically connected to an anode of the light emitting element ED through the sixth transistor T6, and a gate electrode connected to a first end of the capacitor Cst. The first transistor T1 may receive the data signal Dj transferred through the data line DLj depending on a switching operation of the second transistor T2 and may supply a driving current Id to the light emitting element ED.

The second transistor T2 includes a first electrode connected to the data line DLj, a second electrode connected to the first electrode of the first transistor T1, and a gate electrode connected to the scan line GWLi. The second transistor T2 may be turned on depending on the scan signal GWi transferred through the scan line GWLi and may transfer the data signal Dj from the data line DLj to the first electrode of the first transistor T1. For example, a gate electrode of the second transistor T2 may receive the scan signal GWi.

The third transistor T3 includes a first electrode connected to the gate electrode of the first transistor T1, a second electrode connected to the second electrode of the first transistor T1, and a gate electrode connected to the scan line GCLi. The third transistor T3 may be turned on depending on the scan signal GCi transferred through the scan line GCLi, and thus, the gate electrode and the second electrode of the first transistor T1 may be connected to each other, that is, the first transistor T1 may be diode-connected. For example, a gate electrode of the third transistor T3 may receive the scan signal GCi.

The fourth transistor T4 includes a first electrode connected to the gate electrode of the first transistor T1, a second electrode connected to the fourth driving voltage line VL4 through which the second initialization voltage VINT2 is transferred, and a gate electrode connected to the scan line GILi. The fourth transistor T4 may be turned on depending on the scan signal GIi transferred through the scan line GILi, and thus, the second initialization voltage VINT2 may be transferred to the gate electrode of the first transistor T1. For example, a gate electrode of the fourth transistor T4 may receive the scan signal GIi. As such, a voltage of the gate electrode of the first transistor T1 may be initialized. This operation may be referred to as an "initialization operation".

The fifth transistor T5 includes a first electrode connected to the first driving voltage line VL1, a second electrode connected to the first electrode of the first transistor T1, and a gate electrode connected to the emission line EMLi.

The sixth transistor T6 includes a first electrode connected to the second electrode of the first transistor T1, a second electrode connected to the anode of the light emitting element ED, and a gate electrode connected to the emission line EMLi.

The fifth transistor T5 and the sixth transistor T6 may be simultaneously turned on depending on the emission control signal EMi transferred through the emission line EMI,i, and thus, the first driving voltage ELVDD may be compensated for through the diode-connected transistor T1 so as to be supplied to the light emitting element ED. For example, gate electrodes of the fifth and sixth transistors T5 and T6 may receive the emission control signal EMi.

The seventh transistor T7 includes a first electrode connected to the anode of the light emitting element ED, a second electrode connected to the third driving voltage line VL3, and a gate electrode connected to the scan line GBLi. The seventh transistor T7 may be turned on depending on the scan signal GBi transferred through the scan line GBLi and may electrically connect the anode of the light emitting element ED with the third driving voltage line VL3. For example, a gate electrode of the seventh transistor T7 may receive the scan signal GBi.

The first end of the capacitor Cst is connected to the gate electrode of the first transistor T1, and a second end of the capacitor Cst is connected to the first driving voltage line VL1. A cathode of the light emitting element ED may be connected to the second driving voltage line VL2 receiving the second driving voltage ELVSS. The structure of the pixel PX according to an embodiment is not limited to the structure illustrated in FIG. 5. For example, in one pixel PX, the number of transistors, the number of capacitors, and the connection relationship thereof may be variously changed or modified.

The sensor SX is electrically connected to the scan line GWLi, the reset line GRL1, and the readout line RLw.

The sensor SX includes the light sensing element OPD and the sensor driving circuit SDC. The light sensing element OPD may be a photodiode. As an example of the present disclosure, the light sensing element OPD may be an organic photodiode including an organic material as a photoelectric conversion layer. A light sensing anode O_AE of the light sensing element OPD may be connected to a sensing node SN, and a cathode thereof may be connected to the second driving voltage line VL2 transferring the second driving voltage ELVSS.

The sensor driving circuit SDC includes transistors ST1, ST2, and ST3. The transistors ST1, ST2, and ST3 may be the reset transistor ST1, the amplification transistor ST2, and the output transistor ST3, respectively. The transistors ST1, ST2, and ST3 may be also referred to as a "first transistor ST1", a "second transistor ST2", and a "third transistor ST3", respectively.

Some of the reset transistor ST1, the amplification transistor ST2, and the output transistor ST3 may be P-type transistors, and the other(s) thereof may be an N-type transistor. In an embodiment, the reset transistor ST1 is the same N-type transistor as the third transistor T3 of the pixel PX illustrated in FIG. 5, and the amplification transistor ST2 and the output transistor ST3 are the same P-type transistors as the first and second transistors T1 and T2 of the pixel PX illustrated in FIG. 5. However, the present disclosure is not limited thereto. In an embodiment, all of the reset transistor ST1, the amplification transistor ST2, and the output transistor ST3 are P-type transistors. In an embodiment, all of the reset transistor ST1, the amplification transistor ST2, and the output transistor ST3 are N-type transistors.

The reset transistor ST1 includes a first electrode connected to a reset voltage line VL5 receiving the reset voltage VRST, a second electrode connected to the sensing node SN, and a gate electrode connected to the reset line GRL1 receiving the reset signal GR1. The reset transistor ST1 may reset a potential of the sensing node SN to the reset voltage VRST in response to the reset signal GR1.

The amplification transistor ST2 includes a first electrode connected to a sensor driving voltage line VL6 receiving the sensor driving voltage VCOM, a second electrode connected to an intermediate node IN, and a gate electrode connected to the sensing node SN. In an embodiment, the voltage level of the sensor driving voltage VCOM is equal to the voltage level of one of the first driving voltage ELVDD, the first initialization voltage VINT1, or the second initialization voltage VINT2, which is provided to the pixel PX illustrated in FIG. 5. The amplification transistor ST2 may provide a current corresponding to the potential of the sensing node SN to the intermediate node IN.

The output transistor ST3 includes a first electrode connected to the intermediate node IN, a second electrode connected to the readout line RLw, and a gate electrode connected to the scan line GWLi receiving the scan signal GWi. The output transistor ST3 may transfer a sensing signal FSw to the readout line RLw in response to the scan signal GWi.

The circuit configuration of the sensor driving circuit SDC according to the present disclosure is not limited to FIG. 5. The sensor driving circuit SDC illustrated in FIG. 5 is provided only as an example, and the configuration of the sensor driving circuit SDC may be variously modified and implemented.

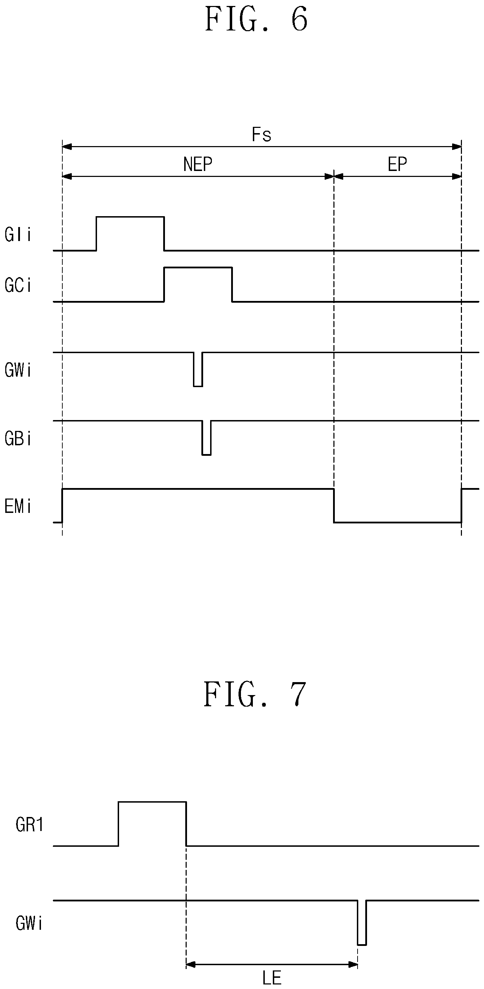

FIG. 6 is a timing diagram for an operation of a pixel illustrated in FIG. 5.

Referring to FIGS. 5 and 6, one frame Fs (or frame period) may include an emission period EP and a non-emission period NEP. The emission period EP may correspond to a low-level period (i.e., an active period) of the emission control signal EMi, and the non-emission period NEP may correspond to a high-level period (i.e., an inactive period) of the emission control signal EMi.

The non-emission period NEP may include an initialization period and a data programming and compensation period.

When the scan signal GIi of the high level is provided through the scan line GILi during the initialization period, the fourth transistor T4 is turned on. The second initialization voltage VINT2 is transferred to the gate electrode of the first transistor T1 through the fourth transistor T4, and thus, the first transistor T1 is initialized.

Next, when the scan signal GCi of the high level is supplied through the scan line GCLi during the data programming and compensation period, the third transistor T3 is turned on. In this case, the first transistor T1 is diode-connected by the third transistor T3 thus turned on and is forward-biased. Afterwards, when the scan signal GWi of the low level is supplied through the scan line GWLi, the second transistor T2 is turned on. According to the above bias condition, a compensation voltage that is obtained by subtracting the threshold voltage of the first transistor T1 from the voltage of the data signal Dj supplied from the data line DLj is applied to the gate electrode of the first transistor T1. That is, a gate voltage applied to the gate electrode of the first transistor T1 may be the compensation voltage.

When the first driving voltage ELVDD and the compensation voltage are respectively applied to opposite ends of the capacitor Cst charges whose amount corresponds to a difference between the first driving voltage ELVDD and the compensation voltage may be stored in the capacitor Cst.

Meanwhile, the seventh transistor T7 is turned on in response to the scan signal GBi of low level, which is transferred through the scan line GBLi. When the seventh transistor T7 is turned on, the anode of the light emitting element ED is electrically connected to the third driving voltage line VL3. Accordingly, the anode of the light emitting element ED may be initialized with the first initialization voltage VINT1.

Afterwards, during the emission period EP, the emission control signal EMi supplied from the emission line EMLi transitions from the high level to the low level. During the emission period EP, the fifth transistor T5 and the sixth transistor T6 are turned on by the emission control signal EMi of the low level. In this case, the driving current Id is generated depending on a difference between the gate voltage of the gate electrode of the first transistor T1 and the first driving voltage ELVDD and is supplied to the light emitting element ED through the sixth transistor T6. That is, the driving current Id flows through the light emitting element ED. The light emitting element ED may emit light with luminance corresponding to the driving current Id.

FIG. 7 is a timing diagram for an operation of the sensor SX illustrated in FIG. 5.

Referring to FIGS. 5 and 7, when the reset signal GR1 transitions to the high level, the reset transistor ST1 is turned on. When the reset transistor ST1 is turned on, the sensing node SN may be initialized with the reset voltage VRST.

After the reset signal GR1 transitions to the low level, the sensor SX is exposed to the light during a light exposure period LE. When the user's hand touches the display surface, the light sensing element OPD may generate photoelectrons, the amount of which corresponds to the light reflected by the user's hand, and the generated photoelectrons may be accumulated at the sensing node SN.

The amplification transistor ST2 may be a source follower amplifier that generates a source-drain current in proportion to the amount of photoelectrons (or charges) of the sensing node SN, which are input to the gate electrode of the amplification transistor ST2.

While the scan signal GWi is at the inactive level, that is, at the high level, the output transistor ST3 is maintained in the turn-off state. When the scan signal GWi transitions to the active level, that is, the low level, the output transistor ST3 is turned on. When the output transistor ST3 is turned on, the sensing signal FSw corresponding to the current flowing through the amplification transistor ST2 may be output to the readout line RLw. That is, the sensing signal FSw corresponding to the amount of light sensed by the light sensing element OPD may be output to the readout line RLw.

In an embodiment, the scan signal GWi of FIG. 7 is the same as the scan signal GWi illustrated in FIGS. 5 and 6. That is, the pixels PX and the sensors SX disposed at the i-th row illustrated in FIG. 3 may receive the same scan signal GWi.

In an embodiment, in the biometric sensing mode, the light sensing element OPD may generate photoelectrons, the amount of which corresponds to the light reflected by a ridge of a fingerprint or a valley between ridges. The sensing signal FSw output from the sensor SX in the biometric sensing mode may be a signal corresponding to the user's fingerprint.

In an embodiment, in the biometric sensing mode, the light sensing element OPD may generate photoelectrons, the amount of which corresponds to the light reflected from a blood vessel located under a dermal layer of the user's skin. In the systole, the blood moves to the periphery, increasing arterial blood volume; in the diastole, the blood volume decreases. This change in blood volume changes the reflected light. The sensing signal FSw output from the sensor SX in the biometric sensing mode may be a signal corresponding to the user's blood pressure.

In an embodiment, in the touch sensing mode, the light sensing element OPD may generate photoelectrons, the amount of which corresponds to the light reflected by the user touch. The sensing signal FSw output from the sensor SX in the touch sensing mode may be a signal indicating whether a touch is made by the user.

FIG. 8 is a cross-sectional view of the display panel DP according to an embodiment of the present disclosure. The first and third transistors T1 and T3 and the reset transistor ST1 of FIG. 5 are partially illustrated in FIG. 8.

Referring to FIG. 8, the display panel DP may include the base layer BL, the circuit layer DP_CL disposed on the base layer BL, the element layer DP_ED, and the encapsulation layer TFE.

The base layer BL may include a synthetic resin layer. The synthetic resin layer may include a thermosetting resin material. While the synthetic resin layer may be a polyimide-based resin layer, the present disclosure is not limited thereto. The synthetic resin layer may include at least one of acrylic resin, methacrylic resin, polyisoprene, vinyl resin, epoxy resin, urethane resin, cellulose resin, siloxane resin, polyamide resin, and perylene resin. In addition, the base layer BL may include a glass substrate, a metal substrate, an organic/inorganic composite substrate, etc.

At least one inorganic layer may be formed on an upper surface of the base layer BL. The inorganic layer may include at least one of aluminum oxide, titanium oxide, silicon oxide, silicon oxynitride, zirconium oxide, and hafnium oxide. The inorganic layer may be formed of multiple layers. The multiple inorganic layers may constitute barrier layers BR1 and BR2 and/or a buffer layer BFL, which will be described later. The barrier layers BR1 and BR2 and the buffer layer BFL may be disposed selectively.

The barrier layers BR1 and BR2 prevents foreign objects from being introduced from the outside. The barrier layers BR1 and BR2 may include a silicon oxide layer and a silicon nitride layer. Each of the silicon oxide layer and the silicon nitride layer may be provided in plurality, and the plurality of silicon oxide layers and the plurality of silicon nitride layers may be alternately stacked.

The barrier layers BR1 and BR2 may include the first barrier layer BR1 and the second barrier layer BR2. A first bottom metal layer BMC1 may be interposed between the first barrier layer BR1 and the second barrier layer BR2. In an embodiment of the present disclosure, the first bottom metal layer BMC1 is omitted.

The buffer layer BFL may be disposed on the barrier layers BR1 and BR2. The buffer layer BFL may increase a bonding force between the base layer BL and a semiconductor pattern and/or a conductive pattern. The buffer layer BFL may include a silicon oxide layer and a silicon nitride layer. The silicon oxide layer and the silicon nitride layer may be alternately stacked.

A first semiconductor pattern may be disposed on the buffer layer BFL. The first semiconductor pattern may include a silicon semiconductor. For example, the silicon semiconductor may include amorphous silicon or polycrystalline silicon. For example, the first semiconductor pattern may include low-temperature polysilicon.

FIG. 8 shows only a portion of the first semiconductor pattern disposed on the buffer layer BFL, and the first semiconductor pattern may be further disposed in any other area. The first semiconductor patterns may be arranged across the pixels in compliance with a specific rule. An electrical property of the first semiconductor pattern may vary depending on whether it is doped. The first semiconductor pattern may include a first area whose conductivity is high and a second area whose conductivity is low. The first area may be doped with an N-type dopant or a P-type dopant. A P-type transistor may include a doping area doped with the P-type dopant, and an N-type transistor may include a doping area doped with the N-type dopant. The second area may be a non-doping area or may be an area doped at a concentration lower than the concentration of the first area.

The conductivity of the first area may be higher than the conductivity of the second area, and the first area may substantially serve as an electrode or a signal line. The second area may substantially correspond to an active area (or channel) of a transistor. In other words, a portion of the first semiconductor pattern may be an active area of a transistor, another portion of the first semiconductor pattern may be a source area or a drain area of the transistor, and the other portion of the first semiconductor pattern may be a connection electrode or a connection signal line.

A first electrode SE1, a channel part A1, and a second electrode D1 of the first transistor T1 are formed from the first semiconductor pattern. The first electrode SE1 and the second electrode D1 of the first transistor T1 extend from the channel part A1 in directions facing away from each other.

A portion of a connection signal line CSL formed from the first semiconductor pattern is illustrated in FIG. 8. The connection signal line CSL may be electrically connected to the second electrode of the sixth transistor T6 (refer to FIG. 5).

A first insulating layer 10 may be disposed on the buffer layer BFL. The first insulating layer 10 may overlap a plurality of pixels in common and may cover the first semiconductor pattern. The first insulating layer 10 may be an inorganic layer and/or an organic layer and may have a single-layer or multi-layer structure. The first insulating layer 10 may include at least one of aluminum oxide, titanium oxide, silicon oxide, silicon nitride, silicon oxynitride, zirconium oxide, and hafnium oxide. In an embodiment, the first insulating layer 10 is a single silicon oxide layer. In addition to the first insulating layer 10, an insulating layer of the circuit layer DP_CL may be an inorganic layer and/or an organic layer and may have a single-layer structure or a multi-layer structure. The inorganic layer may include at least one of the above materials, but the present disclosure is not limited thereto.

A gate electrode G1 of the first transistor T1 is disposed on the first insulating layer 10. The gate electrode G1 may be a part of a metal pattern. The gate electrode G1 of the first transistor T1 overlaps the channel part A1 of the first transistor T1. The gate electrode G1 of the first transistor T1 may serve as a mask in the process of doping the first semiconductor pattern. The gate electrode G1 may include titanium (Ti), silver (Ag), an alloy containing silver (Ag), molybdenum (Mo), an alloy containing molybdenum, aluminum (Al), an alloy containing aluminum, aluminum nitride (AlNx), tungsten (W), tungsten nitride (WNx), copper (Cu), indium tin oxide (ITO), indium zinc oxide (IZO), etc., but the present disclosure is not limited thereto.

A second insulating layer 20 may be disposed on the first insulating layer 10 and may cover the gate electrode G1 of the first transistor T1. The second insulating layer 20 may be an inorganic layer and/or an organic layer and may have a single-layer or multi-layer structure. The second insulating layer 20 may include at least one of silicon oxide, silicon nitride, and silicon oxynitride. In an embodiment, the second insulating layer 20 may have a multi-layer structure including a silicon oxide layer and a silicon nitride layer.

An upper electrode UE and a second bottom metal layer BMC2 may be disposed on the second insulating layer 20. The upper electrode UE may overlap the gate electrode G1. The upper electrode UE may be a part of a metal pattern. A portion of the gate electrode G1 and the upper electrode UE overlapping the portion of the gate electrode G1 may define the capacitor Cst (refer to FIG. 5). According to an embodiment of the present disclosure, the second insulating layer 20 may be replaced with an insulating pattern. In this case, the upper electrode UE may be disposed on the insulating pattern, and the upper electrode UE may serve as a mask forming the insulating pattern from the second insulating layer 20.

The second bottom metal layer BMC2 may be disposed to correspond to a lower portion of an oxide thin film transistor, for example, the third transistor T3. The second bottom metal layer BMC2 may be supplied with a constant voltage or a signal. For example, the constant voltage may be a direct current (DC) voltage.

A third insulating layer 30 may be disposed on the second insulating layer 20 and may cover the upper electrode UE and the second bottom metal layer BMC2. The third insulating layer 30 may have a single-layer or multi-layer structure. For example, the third insulating layer 30 may have a multi-layer structure including a silicon oxide layer and a silicon nitride layer.

A second semiconductor pattern may be disposed on the third insulating layer 30. The second semiconductor pattern may include an oxide semiconductor. The oxide semiconductor may include a plurality of areas that are distinguished from each other depending on whether the metal oxide is reduced. An area (hereinafter referred to as a "reduction area") in which the metal oxide is reduced has higher conductivity than an area (hereinafter referred to as a "non-reduction area") in which the metal oxide is not reduced. The reduction area may substantially serve as a source/drain of a transistor or a signal line. The non-reduction area substantially corresponds to an active area (or a semiconductor area or a channel area) of a transistor. In other words, a portion of the second semiconductor pattern may be an active area of a transistor, another portion thereof may be a source area or a drain area of the transistor, and the other portion thereof may be a connection electrode or a connection signal line.

A first electrode SE3, a channel part A3, and a second electrode D3 of the third transistor T3 are formed from the second semiconductor pattern. The first electrode SE3 and the second electrode D3 include a metal reduced from a metal oxide semiconductor. The first electrode SE3 and the second electrode D3 may extend from the channel part A3 in directions facing away from each other, in a cross-sectional view.

A fourth insulating layer 40 may be disposed on the third insulating layer 30. The fourth insulating layer 40 may overlap the plurality of pixels in common and may cover the second semiconductor pattern. The fourth insulating layer 40 may include at least one of aluminum oxide, titanium oxide, silicon oxide, silicon nitride, silicon oxynitride, zirconium oxide, and a hafnium oxide.

A gate electrode G3 of the third transistor T3 is disposed on the fourth insulating layer 40. The gate electrode G3 may be a part of a metal pattern. The gate electrode G3 of the third transistor T3 overlaps the channel part A3 of the third transistor T3. The gate electrode G3 may serve as a mask in the process of doping the second semiconductor pattern. According to an embodiment of the present disclosure, the fourth insulating layer 40 may be replaced with an insulating pattern.

A fifth insulating layer 50 may be disposed on the fourth insulating layer 40 and may cover the gate electrode G3. The fifth insulating layer 50 may be an inorganic layer.

A first connection electrode CNE10 may be disposed on the fifth insulating layer 50. The first connection electrode CNE10 may be connected to the connection signal line CSL through a first contact hole CH1 penetrating the first to fifth insulating layers 10, 20, 30, 40, and 50.

A sixth insulating layer 60 may be disposed on the fifth insulating layer 50. The sixth insulating layer 60 may be an organic layer. The organic layer may include polymers such as benzocyclobutene (BCB), polyimide, hexamethyldisiloxane (HMDSO), polymethylmethacrylate (PMMA), or polystyrene (PS); a polymer derivative having a phenolic group; an acrylic polymer; an imide-based polymer; an arylether-based polymer; an amide-based polymer; a fluorine-based polymer; a p-xylene-based polymer; a vinyl alcohol-based polymer; or the blend thereof.

A second connection electrode CNE20 may be disposed on the sixth insulating layer 60. The second connection electrode CNE20 may be connected to the first connection electrode CNE10 through a second contact hole CH2 penetrating the sixth insulating layer 60. A seventh insulating layer 70 may be disposed on the sixth insulating layer 60 and may cover the second connection electrode CNE20. The seventh insulating layer 70 may be an organic layer.

A first electrode layer is disposed on the circuit layer DP_CL. A pixel defining layer PDL is formed on the first electrode layer. The first electrode layer may include a first anode R_AE and the light sensing anode O_AE. In an embodiment, the first anode R_AE and the light sensing anode O_AE are disposed on the seventh insulating layer 70. The first anode R_AE may be connected to the second connection electrode CNE20 through a third contact hole CH3 penetrating the seventh insulating layer 70. Only the first anode R_AE corresponding to the red light is illustrated in FIG. 8, but the first electrode layer may further include a second anode corresponding to the green light and a third anode corresponding to the blue light.

First and second film openings PDL-OP1 and PDL-OP2 may be provided in the pixel defining layer PDL. The first film opening PDL-OP1 exposes at least a portion of the first anode R_AE. The second film opening PDL-OP2 exposes at least a portion of the light sensing anode O_AE.

In an embodiment of the present disclosure, the pixel defining layer PDL further includes a black material. The pixel defining layer PDL may further include a black organic dye/pigment such as carbon black or aniline black. The pixel defining layer PDL may be formed by mixing a blue organic material and a black organic material. The pixel defining layer PDL may further include a liquid-repellent organic material.

As illustrated in FIG. 8, the display panel DP may include an emission area PXA-R and a non-emission area NPXA-R adjacent to the emission area PXA-R. The non-emission area NPXA-R may surround the emission area PXA-R. In an embodiment, the emission area PXA-R is defined to correspond to a partial area of the first anode R_AE, which is exposed by the first film opening PDL-OP1.

An emission layer may be disposed on the first electrode layer. The emission layer may include red, green, and blue emission layers. The red, green, and blue emission layers may be respectively disposed in corresponding areas of the first film openings PDL-OP1. The red, green, and blue emission layers may be independently formed in the red, green, and blue pixels PXR, PXG, and PXB illustrated in FIG. 4, respectively. Each of the red, green, and blue emission layers may include an organic material and/or an inorganic material. The red, green, and blue emission layers may generate given color lights, respectively. For example, an emission layer R_EL may generate the red light. An example in which the emission layer R_EL is disposed in an area corresponding to the first film openings PDL-OP1 is illustrated in FIG. 8.

In an embodiment, patterned red, green, and blue emission layers are described as an example, but one emission layer may be disposed in a plurality of emission areas in common. In this case, the emission layer may generate a white light or a blue light. Also, the emission layer may have a multi-layer structure that is referred to as "tandem".

The emission layer R_EL may include a low molecular weight organic material or a high molecular weight organic material as a light emitting material. A cathode CE is disposed on the emission layer R_EL. As an example of the present disclosure, the cathode CE may be disposed in the emission area PXA-R, the non-emission area NPXA-R, and a non-pixel area NPA in common.

The circuit layer DP_CL may further include the sensor driving circuit SDC (refer to FIG. 5). For convenience of description, the reset transistor ST1 included in the sensor driving circuit SDC is illustrated. A first electrode STS1, a channel part STA1, and a second electrode STD1 of the reset transistor ST1 are formed from the second semiconductor pattern. The first electrode STS1 and the second electrode STD1 include a metal reduced from a metal oxide semiconductor. The fourth insulating layer 40 is disposed to cover the first electrode STS1, the channel part STA1, and the second electrode STD1 of the reset transistor ST1. A gate electrode STG1 of the reset transistor ST1 is disposed on the fourth insulating layer 40. In an embodiment, the gate electrode STG1 may be a part of a metal pattern. The gate electrode STG1 of the reset transistor ST1 overlaps the channel part STA1 of the reset transistor ST1.

In an embodiment of the present disclosure, the reset transistor ST1 is disposed on the same layer as the third transistor T3. That is, the first electrode STS1, the channel part STA1, and the second electrode STD1 of the reset transistor ST1 may be formed through the same process as the first electrode SE3, the channel part A3, and the second electrode D3 of the third transistor T3. The gate electrode STG1 of the reset transistor ST1 and the gate electrode G3 of the third transistor T3 may be simultaneously formed through the same process. The first electrode and the second electrode of each of the amplification transistor ST2 and the output transistor ST3 of the sensor driving circuit SDC may be formed through the same process as the first electrode SE1 and the second electrode D1 of the first transistor T1. When the reset transistor ST1 and the third transistor T3 are formed on the same layer through the same process, a process of forming the reset transistor ST1 is not additionally required, and thus, process efficiency and costs may be reduced.

The element layer DP_ED may further include the light sensing element OPD (refer to FIG. 5). Only the light sensing element OPD is illustrated in FIG. 8 as an example.

The light sensing element OPD may include the light sensing anode O_AE, a photoelectric conversion layer O_RL, and a photoelectric cathode O_CE. The light sensing anode O_AE may be disposed on the same layer as the first electrode layer. That is, the light sensing anode O_AE may be disposed on the circuit layer DP_CL, and the light sensing anode O_AE and the first anode R_AE may be simultaneously formed through the same process. The display panel DP may include a sensing area SA and a non-sensing area NSA adjacent to the sensing area SA. The non-sensing area NSA may surround the sensing area SA. In an embodiment, the sensing area SA is defined to correspond to a partial area of the light sensing anode O_AE, which is exposed by the second film opening PDL-OP2.

The second film opening PDL-OP2 of the pixel defining layer PDL exposes at least a portion of the light sensing anode O_AE. The photoelectric conversion layer O_RL is disposed on the portion of the light sensing anode O_AE, which is exposed by the second film opening PDL-OP2. The photoelectric conversion layer O_RL may include an organic photo-sensing material. The photoelectric cathode O_CE may be disposed on the photoelectric conversion layer O_RL. The photoelectric cathode O_CE and the cathode CE may be simultaneously formed through the same process. As an example of the present disclosure, the photoelectric cathode O_CE may be integrally formed with the cathode CE. For example, a single layer may be used to form the photoelectric cathode O_CE and the cathode CE.

Each of the light sensing anode O_AE and the photoelectric cathode O_CE may receive an electrical signal. The photoelectric cathode O_CE and the light sensing anode O_AE may receive different signals. Accordingly, a given electric field may be formed between the light sensing anode O_AE and the photoelectric cathode O_CE. The photoelectric conversion layer O_RL generates an electrical signal corresponding to the light incident onto a sensor. The photoelectric conversion layer O_RL may generate charges by absorbing the energy of the incident light. For example, the photoelectric conversion layer O_RL may include a light-sensitive semiconductor material.

The charges generated by the photoelectric conversion layer O_RL change the electric field between the light sensing anode O_AE and the photoelectric cathode O_CE. The amount of charge generated by the photoelectric conversion layer O_RL may vary depending on whether light is incident onto the light sensing element OPD, the amount of light incident onto the light sensing element OPD, and the intensity of light incident onto the light sensing element OPD. As such, the electric field formed between the light sensing anode O_AE and the photoelectric cathode O_CE may vary. The light sensing element OPD according to the present disclosure may obtain information about at least one the fingerprint, blood pressure, and touch of the user through the change in the electric field between the light sensing anode O_AE and the photoelectric cathode O_CE.

However, this is provided as an example, and the light sensing element OPD may also include a photo transistor in which the photoelectric conversion layer O_RL is used as an active layer. In this case, the light sensing element OPD may obtain fingerprint information by sensing the amount of current flowing through the photo transistor. The light sensing element OPD according to an embodiment of the present disclosure may include various photoelectric conversion elements each capable of generating an electrical signal in response to the change in the amount of light, but the present disclosure is not limited to an embodiment.

The encapsulation layer TFE is disposed on the element layer DP_ED. The encapsulation layer TFE may include at least one inorganic layer or at least one organic layer. According to an embodiment of the present disclosure, the encapsulation layer TFE may include two inorganic layers and an organic layer interposed therebetween. According to an embodiment of the present disclosure, a thin-film encapsulation layer of the encapsulation layer TFE may include a plurality of inorganic layers and a plurality of organic layers, which are alternately stacked.

An inorganic layer of the encapsulation layer TFE protects the light emitting element ED_R and the light sensing element OPD from moisture/oxygen, and an organic layer of the encapsulation layer TFE protects the light emitting element ED_R and the light sensing element OPD from foreign substances such as dust particles. The inorganic layer of the encapsulation layer TFE may include a silicon nitride layer, a silicon oxynitride layer, a silicon oxide layer, a titanium oxide layer, an aluminum oxide layer, etc., but the present disclosure is not particularly limited thereto. The organic layer of the encapsulation layer TFE may include an acryl-based organic layer, but the present disclosure is not limited thereto.

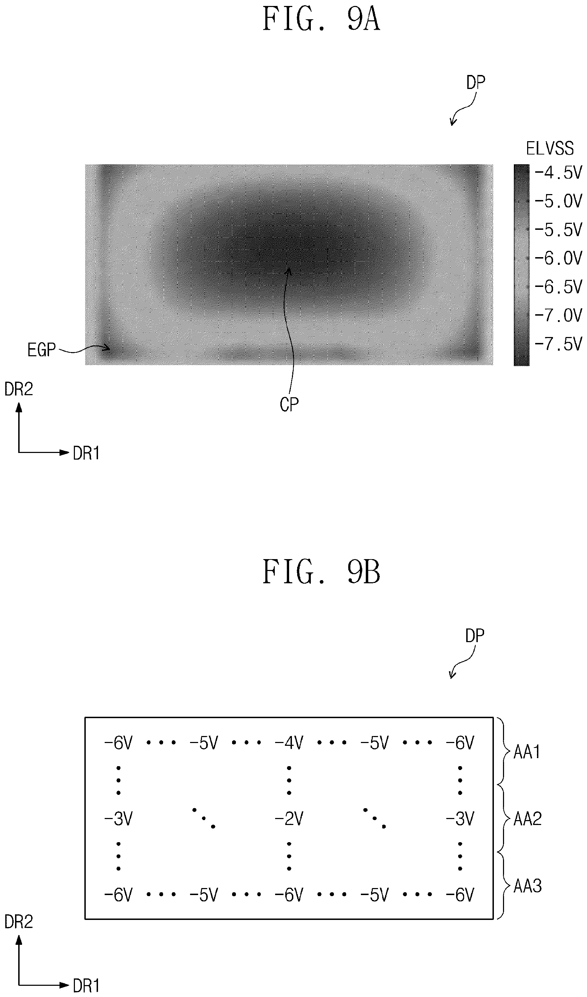

FIGS. 9A and 9B are diagrams illustrating a voltage distribution of the second driving voltage ELVSS in the display panel DP.

Referring to FIGS. 3, 9A, and 9B, even though the voltage generator 500 generates the second driving voltage ELVSS at a uniform voltage level, the voltage level of the second driving voltage ELVSS may vary depending on an image displayed in the display panel DP or an ambient environment (e.g., an ambient temperature). In particular, the second driving voltage ELVSS may vary depending on a location of the display panel DP. For example, a voltage level (e.g., -2V) of the second driving voltage ELVSS in a central portion CP of the display panel DP and a voltage level (e.g., -6V) of the second driving voltage ELVSS in an edge portion EGP of the display panel DP may be different from each other. The reason is as follows. While the second driving voltage ELVSS is supplied from the edge portion EGP of the display panel DP, the voltage level of the second driving voltage ELVSS may change due to a current-resistance (IR) drop phenomenon in the central portion CP of the display panel DP.

The voltage distribution of the second driving voltage ELVSS illustrated in FIGS. 9A and 9B is provided only as an example, and the present disclosure is not limited thereto.

Meanwhile, to reduce power consumption of the pixels PX in the display panel DP, the driving controller 100 may change the voltage level of the second driving voltage ELVSS. That is, the driving controller 100 may change the voltage level of the second driving voltage ELVSS depending on the luminance (or a luminance level) of an image to be displayed in the display panel DP or an emission amount.

As illustrated in FIG. 5, the cathode of the light emitting element ED and the cathode of the light sensing element OPD are connected in common to the second driving voltage line VL2 through which the second driving voltage ELVSS is transferred. That is, when the voltage level of the second driving voltage ELVSS provided to the pixel PX changes, the voltage level of the second driving voltage ELVSS provided to the sensor SX also changes.

When the voltage level of the second driving voltage ELVSS changes, a difference between the reset voltage VRST and the second driving voltage ELVSS, that is, a potential difference of the reset voltage line VL5 and the second driving voltage line VL2 changes. The difference between the reset voltage VRST and the second driving voltage ELVSS or the potential difference may cause a change in a voltage level of the sensing node SN. Thus, a current amount of the intermediate node IN that is determined by the reset transistor ST1 and the amplification transistor ST2 may change. In this case, a characteristic of the sensor SX may change, thereby reducing the sensing sensitivity of the readout circuit 600 (refer to FIG. 3).

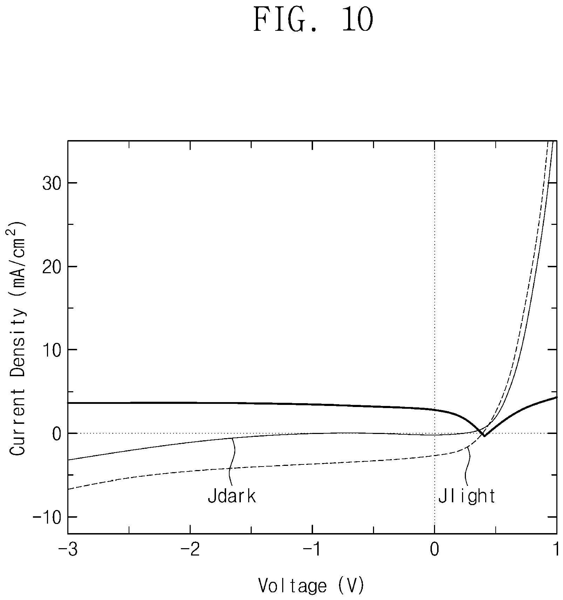

FIG. 10 is a diagram illustrating a change in a current density of the light sensing element OPD.

In FIG. 10, a horizontal axis represents a difference between the reset voltage VRST and the second driving voltage ELVSS, and a vertical axis represents a current density.

Referring to FIG. 10, a curve Jdark shows a change in the current density of the light sensing element OPD due to a difference between the reset voltage VRST and the second driving voltage ELVSS when there is no external light. A curve Jlight shows a change in the current density of the light sensing element OPD due to a difference between the reset voltage VRST and the second driving voltage ELVSS when there is an external light.

Comparing the curve Jdark and the curve Jlight, as the difference between the reset voltage VRST and the second driving voltage ELVSS increases from 0 V to -3 V, the variations in the current density of the curve Jlight become greater than that of the curve Jdark.

That a current flowing through the light sensing element OPD changes depending on the difference between the reset voltage VRST and the second driving voltage ELVSS means that a light sensing characteristic of the sensor SX changes.

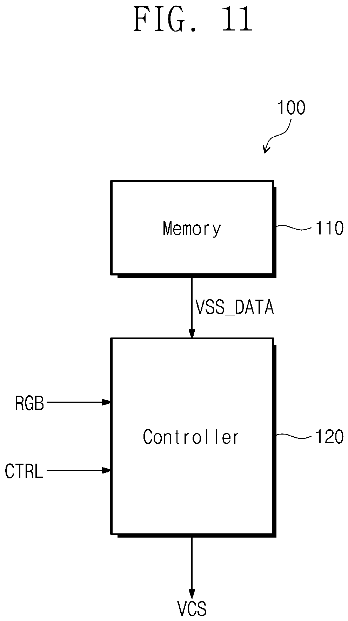

FIG. 11 is a block diagram illustrating the driving controller 100 according to an embodiment of the present disclosure.

Only components associated with an aspect of generating the voltage control signal VCS of the driving controller 100 are illustrated in FIG. 11. The driving controller 100 may further include various components in addition to the components illustrated in FIG. 11.

Referring to FIG. 11, the driving controller 100 includes a memory 110 and a controller 120 (e.g., a control circuit).

The controller 120 may determine the voltage level of the second driving voltage ELVSS based on the input image signal RGB and the control signal CTRL. Also, the controller 120 may determine the voltage level of the reset voltage VRST corresponding to the voltage level of the second driving voltage ELVSS thus determined. That is, when the voltage level of the reset voltage VRST is changed, the voltage level of the second driving voltage ELVSS may also be changed. Thus, the voltage level of the reset voltage VRST is changed depending on the determined voltage level of the driving voltage ELVSS. Thus, even if a voltage level of a driving voltage ELVSS provided to a pixel and/or the sensor changes, performance of the display device can be secured since a characteristic of the sensor may be prevented from varying depending on the change in the second driving voltage.

The voltage level of the reset voltage VRST may be maintained if the voltage level of the second driving voltage ELVSS has not changed based on the input image signal RGB and the control signal CTRL.

In an embodiment, the memory 110 stores information about the voltage distribution (refer to FIG. 9B) of the second driving voltage ELVSS provided to the display panel DP, that is, a voltage data signal VSS_DATA. For example, the memory 110 may include entries for each portion (or block) of an image to be displayed on the display panel DP and a value of the second driving voltage ELVSS for the corresponding portion.

The controller 120 reads the voltage data signal VSS_DATA associated with the second driving voltage ELVSS from the memory 110. For example, the voltage data signal VSS_DATA may indicate a voltage level of the second driving voltage ELVSS for a corresponding portion of the image to be displayed. The voltage level of the reset voltage VRST for the corresponding portion may be determined from the voltage data signal VSS_DATA. Thus, since voltage levels of reset signals VRST provided to reset lines may vary, e.g. depending on locations of the reset lines, a characteristic change of the sensor may be compensated for by setting the voltage levels of the reset signals depending on the voltage distribution of the second driving voltage ELVSS. The controller 120 may determine the voltage level of the reset control voltage VGR based on the voltage data signal VSS_DATA. The voltage level of the reset control voltage VGR may be for operating a certain part of the display panel DP that will display the corresponding portion of the image.

The controller 120 may output the voltage control signal VCS corresponding to the determined voltage level of the second driving voltage ELVSS, the determined voltage level of the reset voltage VRST, and/or the determined voltage level of the reset control voltage VGR.

The voltage generator 500 illustrated in FIG. 3 changes the voltage levels of the second driving voltage ELVSS, the reset voltage VRST, and/or the reset control voltage VGR in response to the voltage control signal VCS.

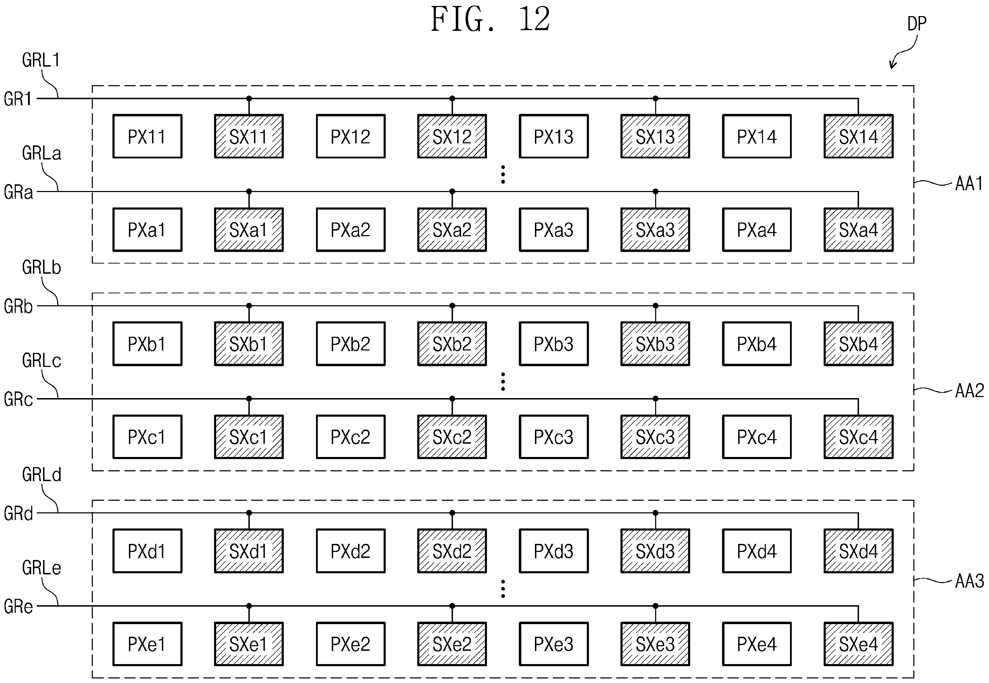

FIG. 12 is a diagram illustrating pixels and sensors disposed in the display panel DP.

Referring to FIG. 12, the display panel DP may include a first area AA1, a second area AA2, and a third area AA3. An example in which the display panel DP includes three areas AA1, AA2, and AA3 is illustrated in FIG. 12, but the present disclosure is not limited thereto.

The first area AA1 includes pixels PX11, PX12, PX13, PX14, PXa1, PXa2, PXa3, and PXa4 and sensors SX11, SX12, SX13, SX14, SXa1, SXa2, SXa3, and SXa4.

The second area AA2 includes pixels PXb1, PXb2, PXb3, PXb4, PXc1, PXc2, PXc3, and PXc4 and sensors SXb1, SXb2, SXb3, SXb4, SXc1, SXc2, SXc3, and SXc4.

The third area AA3 includes pixels PXd1, PXd2, PXd3, PXd4, PXe1, PXe2, PXe3, and PXe4 and sensors SXd1, SXd2, SXd3, SXd4, SXe1, SXe2, SXe3, and SXe4.

The reset line GRL1 is connected to the sensors SX11, SX12, SX13, and SX14 of the first area AA1. A reset line GRLa is connected to the sensor SXa1, SXa2, SXa3, and SXa4 of the first area AA1.

A reset line GRLb is connected to the sensors SXb1, SXb2, SXb3, and SXb4 of the second area AA2. A reset line GRLc is connected to the sensors SXc1, SXc2, SXc3, and SXc4 of the second area AA2.

A reset line GRLd is connected to the sensors SXd1, SXd2, SXd3, and SXd4 of the third area AA3. A reset line GRLe is connected to the sensors SXe1, SXe2, SXe3, and SXe4 of the third area AA3.

The reset lines GRL1, GRLa, GRLb, GRLc, GRLd, and GRLe may transfer reset signals GR1, GRa, GRb, GRc, GRd, and GRe, which are provided from the scan and sensor driver 300 illustrated in FIG. 3, to sensors connected thereto, respectively.

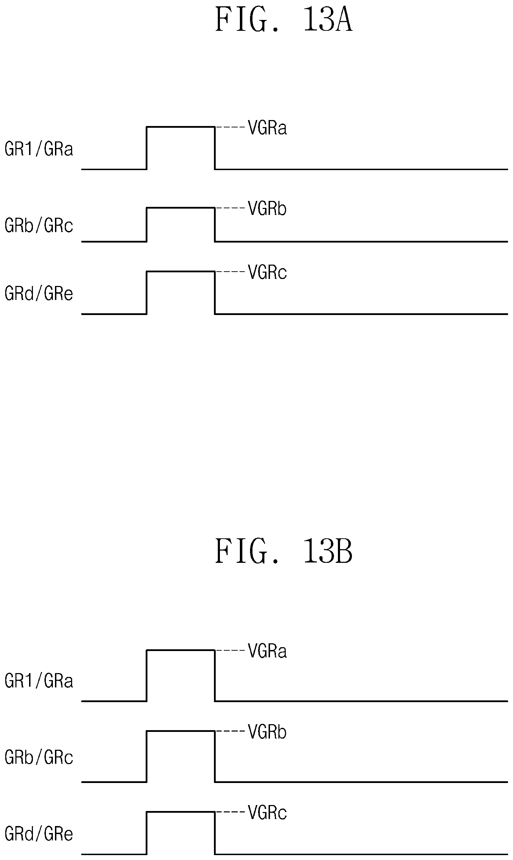

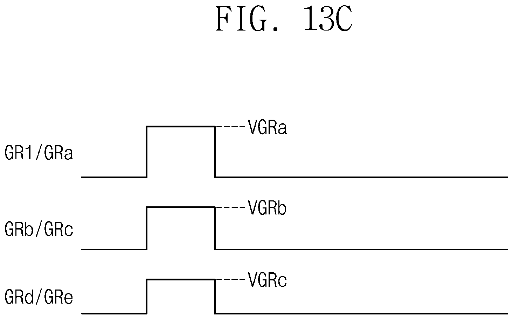

FIGS. 13A, 13B, and 13C are diagrams illustrating reset signals provided to reset lines illustrated in FIG. 12.

Referring to FIGS. 11, 13A, 13B, and 13C, the memory 110 may store information about the voltage distribution (refer to FIG. 9B) of the second driving voltage ELVSS provided to the display panel DP and may provide the voltage data signal VSS_DATA to the controller 120. The voltage data signal VSS_DATA may be determined from the information about the voltage distribution.

The controller 120 may determine the voltage level of the reset control voltage VGR based on the voltage data signal VSS_DATA.

For example, the controller 120 may determine a voltage level VGRa of the reset control voltage VGR corresponding to the first area AA1 based on the voltage distribution of the second driving voltage ELVSS, which corresponds to the first area AA1 of the display panel DP.

The controller 120 may determine a voltage level VGRb of the reset control voltage VGR corresponding to the second area AA2 based on the voltage distribution of the second driving voltage ELVSS, which corresponds to the second area AA2 of the display panel DP.

The controller 120 may determine a voltage level VGRc of the reset control voltage VGR corresponding to the third area AA3 based on the voltage distribution of the second driving voltage ELVSS, which corresponds to the third area AA3 of the display panel DP.

In an embodiment, when the voltage distribution of the second driving voltage ELVSS provided to the display panel DP is uniform, the voltage levels VGRa, VGRb, and VGRc of the reset control voltage VGR, which respectively correspond to the first area AA1, the second area AA2, and the third area AA3, are identical.

In an embodiment, when the voltage distribution of the second driving voltage ELVSS provided to the display panel DP is not uniform, some of the voltage levels VGRa, VGRb, and VGRc of the reset control voltage VGR, which respectively correspond to the first area AA1, the second area AA2, and the third area AA3, may be identical, and the other(s) thereof may be different.

The controller 120 may determine the voltage levels VGRa, VGRb, and VGRc of the reset control voltage VGR, which correspond to each of the first area AA1, the second area AA2, and the third area AA3, and may output the voltage control signal VCS corresponding to the determined voltage levels.

The voltage generator 500 illustrated in FIG. 3 may change the voltage level of the reset control voltage VGR in response to the voltage control signal VCS. In particular, the voltage generator 500 may differently set the voltage level of the reset control voltage VGR depending on the first area AA1, the second area AA2, and the third area AA3.

In the example illustrated in FIGS. 13A, 13B, and 13C, reset signals GR1 and GRa corresponding to the first area AA1 may be identical to each other, reset signals GRb and GRc corresponding to the second area AA2 may be identical to each other, and reset signals GRd and GRe corresponding to the third area AA3 may be identical to each other.

When each of the reset signals GR1, GRa, GRb, GRc, GRd, and GRe transitions to the high level, the reset transistor ST1 of the sensor SX (refer to FIG. 5) may be turned on.

In the example illustrated in FIGS. 13A, 13B, and 13C, high levels of the reset control voltage VGR, which correspond to each of the first area AA1, the second area AA2, and the third area AA3, respectively correspond to the voltage levels VGRa, VGRb, and VGRc of the reset control voltage VGR.

In the example illustrated in FIG. 13A, the high level of the reset signals GR1 and GRa corresponding to the first area AA1 and the high level of the reset signals GRd and GRe corresponding to the third area AA3 are identical to each other. That is, the voltage levels VGRa and VGRc are identical to each other. Also, the high level of the reset signals GR1 and GRa corresponding to the first area AA1 and the high level of the reset signals GRb and GRc corresponding to the second area AA2 are different from each other. That is, the voltage level VGRa is higher than the voltage level VGRb.

In the example illustrated in FIG. 13B, the high level of the reset signals GR1 and GRa corresponding to the first area AA1 and the high level of the reset signals GRb and GRc corresponding to the second area AA2 are identical to each other. That is, the voltage levels VGRa and VGRb are identical to each other. Also, the high level of the reset signals GR1 and GRa corresponding to the first area AA1 and the high level of the reset signals GRd and GRe corresponding to the third area AA3 are different from each other. That is, the voltage level VGRa is higher than the voltage level VGRc.

In the example illustrated in FIG. 13C, the high level of the reset signals GR1 and GRa corresponding to the first area AA1, the high level of the reset signals GRb and GRc corresponding to the second area AA2, and the high level of the reset signals GRd and GRe corresponding to the third area AA3 are different from each other. For example, the voltage level VGRa is higher than the voltage level VGRb, and the voltage level VGRb is higher than the voltage level VGRc.

In the example illustrated in FIGS. 9A and 9B, the voltage level of the second driving voltage ELVSS at the central portion CP of the display panel DP is higher than the voltage level of the second driving voltage ELVSS at the edge portion EGP thereof. As the voltage level of the second driving voltage ELVSS increases, the difference between the reset voltage VRST and the second driving voltage ELVSS may become greater; in this case, as illustrated in FIG. 13A, the high level of the reset signals GRb and GRc corresponding to the second area AA2 are adjusted (or controlled) to be lower than the voltage levels VGRa and VGRc

In this case, because the reset transistor ST1 (refer to FIG. 5) of each of sensors SX disposed in the second area AA2 is weakly turned on, the current of the sensing node SN may be adjusted. That is, the characteristic of the sensors SX disposed in the second area AA2 may be similar to the characteristic of the sensors SX disposed in the first area AA1 and the third area AA3.

In an embodiment, the controller 120 determines a voltage level associated with the second driving voltage ELVSS at a certain position of the display panel based on a voltage distribution of the second driving voltage ELVSS and determines a difference between the voltage level and a present voltage level of a reset voltage for the certain position. In a first embodiment, the reset voltage for a sensor at the certain position is maintained when the difference does not exceed a threshold (e.g., see VGRa or VGRc in FIG. 13A) and the reset voltage for the sensor at the certain position is decreased when the difference exceeds the threshold (e.g., see VGRb in FIG. 13A). In a second embodiment, the reset voltage for a sensor at the certain position is maintained when the difference does not exceed a first threshold (e.g., see VGRa in FIG. 13C), the reset voltage for the sensor at the certain position is decreased by a first amount when the difference exceeds the first threshold but does not exceed a second threshold greater than the first threshold (e.g., see VGRb in FIG. 13C), and the reset voltage for the sensor at the certain position is decreased by a second amount larger than the first amount when the difference exceeds the second threshold (e.g., see VGRc in FIG. 13C). Thus, a present level of the reset voltage for a certain position may be dynamically adjusted to a new level based on a difference between the present level and a value associated with the second driving voltage ELVSS at that certain position.

The characteristic change of the sensor SX according to the voltage distribution of the second driving voltage ELVSS provided to the display panel DP may be compensated for by adjusting the voltage levels VGRa, VGRb, and VGRc of the reset signals GR1, GRa, GRb, GRc, GRd, and GRe for each area of the display panel DP.

According to a sensor and a display device with the above configuration, when a voltage level of a second driving voltage changes, a voltage level of a reset voltage changes. Accordingly, a characteristic of the sensor may be prevented from varying depending on the change in the second driving voltage.

Also, voltage levels of reset signals provided to reset lines may vary depending on locations of the reset lines. That is, a characteristic change of the sensor may be compensated for by setting the voltage levels of the reset signals depending on a voltage distribution of the second driving voltage.

## Claims

1. A display device comprising:
At least one pixel (PX) including a light emitting element (ED) connected to a driving voltage line (VL2) transferring a driving voltage (ELVSS);
At least one sensor (SX) including a light sensing element (OPD) connected to the driving voltage line (VL2) and a reset voltage line (VL5) receiving a reset voltage (VRST);
a driving controller (120) configured to receive an image signal (RGB) and a control signal (CTRL); and
a voltage generator (500) configured to generate the driving voltage (ELVSS) and the reset voltage (VRST) in response to a voltage control signal (VCS),
wherein the driving controller (120) is configured to:
determine a voltage level of the driving voltage (ELVSS) based on the image signal (RGB) and the control signal (CTRL);
determine a voltage level of the reset voltage (VRST) based on the determined voltage level of the driving voltage (ELVSS); and
output the voltage control signal (VCS) corresponding to the voltage level of the driving voltage (ELVSS) and the voltage level of the reset voltage (VRST).

2. The display device of claim 1, wherein the light sensing element (OPD) connected between a sensing node (SN) and the driving voltage line (VL2), and
wherein the sensor (SX) comprises:
a first transistor (ST1) connected between the reset voltage line (VL5) and the sensing node (SN);
a second transistor (ST2) connected between a sensor driving voltage line (VL6) and an intermediate node (IN) and including a gate electrode connected to the sensing node (SN); and
a third transistor (ST3) connected between the intermediate node (IN) and a readout line (RLw) and including a gate electrode connected to a scan line (GWLi).

3. The display device of any of the preceding claims 1 to 2, wherein the first transistor (ST1) is a transistor of a first type, and
wherein the second transistor (ST2) and the third transistor (ST3) are transistors of a second type different from the first type.

4. The display device of any of the preceding claims 1 to 3, wherein the light sensing element (OPD) includes a cathode connected to the driving voltage line (VL2) and an anode connected to the sensing node (SN), and
wherein the light emitting element (ED) includes a cathode connected to the driving voltage line (VL2) and an anode.

5. The display device of any of the preceding claims 1 to 4, wherein the driving controller (120) comprises:
a memory (110) configured to store a voltage data signal (VSS_DATA) including information about a voltage distribution of the driving voltage (ELVSS) provided to a display panel (DP); and
a controller (120) configured to:
receive the voltage data signal (VSS_DATA) from the memory (110),
determine a voltage level of a reset control voltage (VGR) based on the voltage data signal (VSS_DATA), and
output the voltage control signal (VCS) corresponding to the voltage level of the reset control voltage (VGR).

6. The display device of claim 5, wherein the voltage generator (500) is further configured to generate the reset control voltage (VGR) in response to the voltage control signal (VCS).

7. The display device of claim 6, further comprising:
a sensor driver (300) configured to:
output a scan signal (GCLi, GILi, GBLi, GWLi) for driving the pixel (PX), and
output a reset signal (GR1) for driving the sensor (SX).

8. The display device of claim 7, wherein the sensor driver (300) is configured to output the reset signal (GR1) corresponding to the voltage level of the reset control voltage (VGR).

9. The display device of claim 8, wherein the first transistor (ST1) includes a gate electrode configured to receive the reset signal (GR1).

10. The display device of claim 1 further comprising:
a display panel (DP);
a plurality of pixels (PX) and sensors (SX) provided in the display panel (DP);
wherein each of the sensors (SX) includes the light sensing element (OPD) connected to the driving voltage line (VL2) for receiving the driving voltage (ELVSS) and the reset voltage line (VL5) for receiving the reset voltage (VRST).

11. The display device of claim 10, wherein the voltage generator (500) is further configured to generate a reset control voltage (VGR) in response to the voltage control signal (VCS), and the sensor driver (300) is configured to output the reset signals (GRL1, GRLa, ..., GRLe) corresponding to a voltage level of the reset control voltage (VGR).

12. The display device of any of the preceding claims 10 to 11, wherein the display panel (DP) comprises a first area (AA1) and a second area (AA2), and the sensors (SX) include a first sensor (SX11, ..., SX14; SXa1, ..., SXa4) disposed in the first area (AA1) and a second sensor (SXb1, ..., SXb4; SXc1, ..., SXc4) disposed in the second area (AA2).

13. The display device of claim 12, wherein the reset signals include a first reset signal (GR1, GRa) to be provided to the first sensor (SX11, ..., SX14; SXa1, ..., SXa4) and a second reset signal (GRb, GRc) to be provided to the second sensor (SXb1, ..., SXb4; SXc1, ..., SXc4), and a voltage level of the first reset signal (GR1, GRa) and a voltage level of the second reset signal (GRb, GRc) are different from each other.

14. The display device of any of the preceding claims 1 to 13, wherein the display panel (DP) comprises a base layer (BL), a circuit layer (DP_CL) disposed on the base layer (BL), the first transistor (ST1) and the second transistor (ST2) being disposed in the circuit layer (DP_CL), and an element layer (DP_ED) disposed on the circuit layer (DP_CL) and including the light sensing element (OPD).

15. The display device of any of the preceding claims 1 to 14, wherein the driving controller (120) is configured to determine the voltage level of the reset voltage (VRST) by changing the voltage level of the reset voltage (VRST) depending on the determined voltage level of the driving voltage (ELVSS).
